# EUROPEAN PATENT SPECIFICATION

(11) **EP 2 312 607 B1**
(45) Date of publication and mention of the grant of the patent: **03.04.2013**
(21) Application number: 10187875.9
(22) Date of filing: 18.10.2010
(51) Int. Cl.: H05K 9/00, H05K 7/20, H01J 11/12

(54) **Plasma display apparatus to reduce EMI emission**
Plasmaanzeigevorrichtung zur Verringerung der EMI-Strahlung
Appareil d'affichage à plasma pour réduire l'émission d'EMI

(30) Priority: 19.10.2009 KR 20090099264; 13.11.2009 KR 20090109699
(43) Date of publication of application: 20.04.2011
(73) Proprietor: Samsung Electronics Co., Ltd., Suwon-si, Gyeonggi-do, 443-742 (KR)
(72) Inventor: Han, Joon-Mok, Gyeonggi-do (KR); Shon, Young-ki, Gyeonggi-do (KR); Kim, Hong-jin, Gyeonggi-do (KR); Jung, Jae-wook, Gyeonggi-do (KR)
(74) Representative: Grootscholten, Johannes A.M.

(56) References cited:
- EP-A2- 1 696 455
- US-A1- 2006 098 412
- US-A1- 2008 203 913
- GrafTech International Holdings Inc.: "Thermal Solutions for Displays: PDP Applications", , 2008, XP002628284, Retrieved from the Internet: URL:http://www.graftechaet.com/CMSPages/Ge tFile.aspx?guid=16bb6fe8-f6cb-4170-ad70-3b e97dddc08a [retrieved on 2011-03-15]
- GrafTech International Holdings Inc.: "Technical Data Sheet: eGraf SPREADERSHIELD Heat Spreader Selector Guide", , 15 February 2011 (2011-02-15), XP002628285, Retrieved from the Internet: URL:http://www.graftechaet.com/CMSPages/Ge tFile.aspx?guid=a559d62b-af95-4c7a-a5ea-90 0cc9754f9e [retrieved on 2011-03-15]
- GrafTech International Holdings Inc.: "Technical Bulletin: Typical SPREADERSHIELD EMI Properties", , 27 May 2008 (2008-05-27), XP002628286, Retrieved from the Internet: URL:http://www.graftechaet.com/CMSPages/Ge tFile.aspx?guid=572d237e-d445-4145-82fe-0e 7b697afe22 [retrieved on 2011-03-15]

## Description

### BACKGROUND

### 1. Field

Apparatuses and methods consistent with the exemplary embodiments relate to a plasma display apparatus to reduce electromagnetic interference (EMI) emission, and more particularly, to a plasma display apparatus to reduce EMI emission using spread sheets.

### 2. Description of the Related Art

Flat display apparatuses are generally used for portable devices and are rapidly replacing cathode ray tube (CRT) displays due to development of large display technologies in the flat display field.

Plasma display panels (PDPs) are a kind of flat display apparatus which display text or graphics using light emitted from plasma generated by gas discharge. Compared with other kinds of flat display apparatuses, PDPs have high luminance, a high efficiency of light emission, and a wide viewing angle, and are thus widespread today.

One of the shortcomings of display panels is that large electromagnetic wave noise is generated while display panels are operating, thereby causing electromagnetic interference (EMI). That is, since a voltage of approximately 200 V and a root mean square (RMS) electric current of greater than approximately 2 A are transmitted to electrodes constituting a plasma display panel, energy of a driving wave causing discharge emits EMI using the electrodes on the panel as an antenna.

EMI causes electromagnetic wave noise interruption which may obstruct reception of a desired electromagnetic signal, thereby causing malfunctioning of an electronic device. In addition, EMI is absorbed in human bodies as an electronic energy and thus raises body temperature, thereby damaging tissues and functions of the body.

Therefore, there is a need for methods for reducing EMI while operating a display panel.

It is acknowledged here that US-2008/0203913 and EP-1696455 constitute prior art in relation to the present invention, relative to which at least features in the characterizing portion of claim 1 are novel.

### SUMMARY OF THE INVENTION

Exemplary embodiments address at least the above problems and/or disadvantages and other disadvantages not described above. Also, an exemplary embodiment is not required to overcome the disadvantages described above, and an exemplary embodiment may not overcome any of the problems described above.

An aspect of an exemplary embodiment provides a plasma display apparatus to reduce EMI emission using spread sheets.

According to an aspect of an exemplary embodiment, there is provided a plasma display apparatus including all features of claim 1, including the characterizing portion thereof.

The plurality of conductive substances may be a plurality of conductive gaskets, and the base chassis may be connected to the second surfaces of the plurality of conductive sheets through at least one respective conductive gasket.

The plurality of conductive sheets may be a plurality of thermal spread sheets (TSSs) to dissipate heat from the plasma display apparatus, and the first surfaces of the plurality of conductive sheets may be connected to the rear surface of the lower panel in a form that the plurality of conductive sheets are arranged parallel to or perpendicular to a direction in which the driving electrode is arranged.

The plasma display apparatus may further include a driving circuit which is mounted on a surface of the base chassis opposite a surface of the base chassis which is connected to the plurality of conductive sheets, and which is connected to the driving electrode, wherein an electric current which is generated by the driving circuit and is transmitted to the driving electrode returns to the driving circuit through the plurality of conductive sheets and the base chassis.

The plurality of conductive sheets are formed so as to reduce a return path of the electric current.

The first surfaces of the plurality of conductive sheets may be connected to the rear surface of the lower panel in the divided form that the plurality of conductive sheets are arranged parallel to or perpendicular to a direction in which the driving electrode is arranged.

The plurality of conductive sheets may be divided in a form that a capacitance formed between each conductive sheet and the driving electrode is reduced as compared with when the plurality of conductive sheets are integrated as a single conductive sheet.

An active area in which the driving electrode is arranged and from which electromagnetic interference (EMI) is emitted may be included in an area parallel to the lower panel, and an area for the plurality of conductive sheets may be included in an area perpendicular to the active area.

The conductive sheets may be E-Graf.

According to an aspect of another exemplary embodiment, there is provided a plasma display apparatus including: a first conductive sheet which is attached to a first area of a display panel; a second conductive sheet which is attached to a second area of the display panel and is spaced apart a predetermined distance from the first conductive sheet; and a base chassis which is connected to the first conductive sheet through at least one first conductive connection element, and is connected to the second conductive sheet through at least one second conductive connection element.

The predetermined distance may be a distance which is set to minimize a level of EMI generated by the display panel.

The first area of the display panel may be an area which is adjacent to an X driving circuit to drive the display panel, and the second area of the display panel may be an area which is adjacent to a Y driving circuit to drive the display panel.

### BRIEF DESCRIPTION OF THE DRAWINGS

The above and/or other aspects will be more apparent by describing certain exemplary embodiments with reference to the accompanying drawings, in which:
FIG. 1 is a side-sectional view of a plasma display apparatus according to an exemplary embodiment;
FIG. 2 is a partially exploded perspective view of a plasma display apparatus according to an exemplary embodiment;
FIG. 3 illustrates a method for operating a plasma display apparatus according to an exemplary embodiment;
FIGs. 4A to 4C illustrate a detailed structure of a panel according to an exemplary embodiment;
FIG. 5 illustrates a form of arrangement of electrodes according to an exemplary embodiment;
FIG. 6 illustrates a form of a thermal spread sheet (TSS) and structure of a connection between the TSS and a base chassis according to an exemplary embodiment;
FIG. 7 illustrates an active area according to an exemplary embodiment; and
FIG. 8 illustrates amounts of emitted EMI according to a form of a TSS according to an exemplary embodiment.

### DETAILED DESCRIPTION OF EXEMPLARY EMBODIMENTS

Certain exemplary embodiments of the present invention will now be described in greater detail with reference to the accompanying drawings. In the following description, like drawing reference numerals are used for like elements, even in different drawings. The matters defined in the description, such as detailed construction and elements, are provided to assist in a comprehensive understanding of the exemplary embodiments. However, the exemplary embodiments can be practiced without those specifically defined matters. Also, well-known functions or constructions are not described in detail since they would obscure the exemplary embodiments with unnecessary detail.

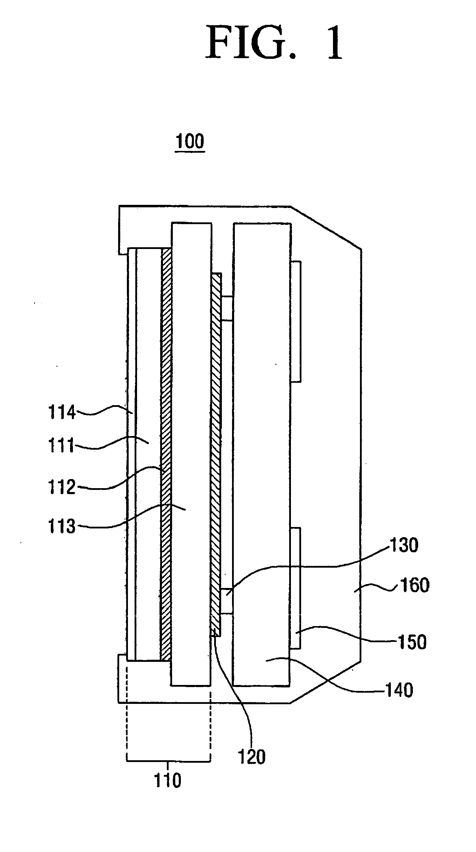

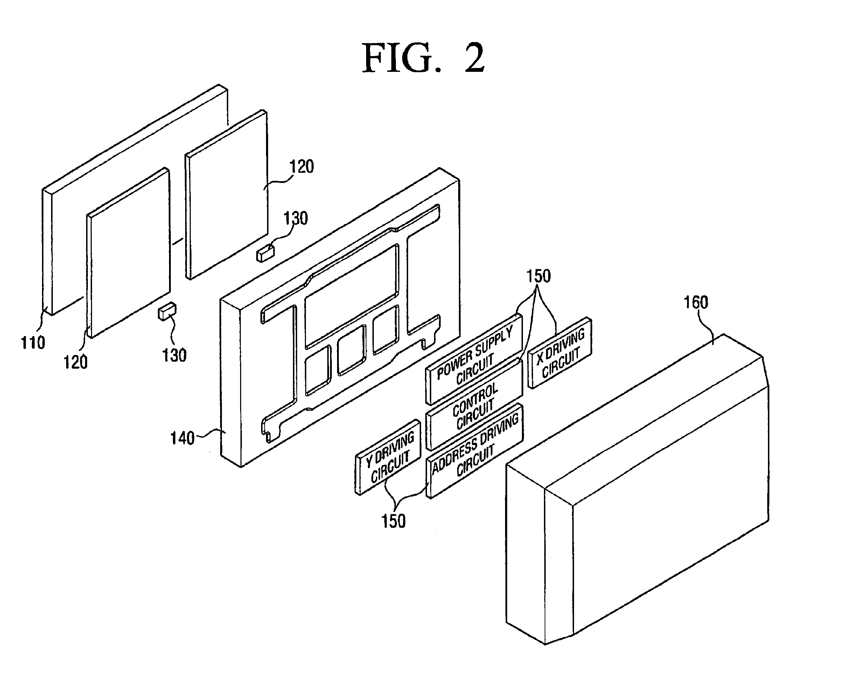

FIG. 1 is a side-sectional view of a plasma display apparatus 100 according to an exemplary embodiment, and FIG. 2 is a partially exploded perspective view of the plasma display apparatus 100. The plasma display apparatus 100 meets electromagnetic wave standard for electromagnetic interference (EMI) and provides a viewer with viewable images.

Referring to FIGs. 1 and 2, the plasma display apparatus 100 includes a panel 110, a plurality of thermal spread sheets (TSS) 120, a plurality of gaskets 130, a base chassis 140, a driving circuit 150, and a cover 160.

The panel 110 realizes an image by exciting a fluorescent substance using vacuum ultraviolet rays generated by an internal gas electric discharge. The panel 110 may include an upper panel 111 and a lower panel 113. An edge of the upper panel 111 is connected to an edge of the lower panel 113 using a sealing substance 112 such as frit so as to form a single panel 110. A plurality of discharge cells are formed in a space between the upper panel 111 and the lower panel 113 sealed by the sealing substance 112, and each discharge cell is filled with neon (Ne) and xenon (Xe).

In each discharge cell, electrodes which are connected to the driving circuit 150 are arranged. If the driving circuit 150 supplies the voltage to the electrodes, the plasma display apparatus 100 operates. A detailed description of a method for operating the plasma display apparatus 100 according to an exemplary embodiment is given below.

A glass filter 114 is attached to or coated on an upper side of the upper panel 111 for surface reflection prevention, color correction, near infrared ray absorption, EMI blocking, etc. The glass filter 114 may be formed in a single filter layer or in a plurality of filter layers which differ from each other according to their function.

A filter layer for surface reflection prevention may prevent a viewer from viewing glare and prevent scratches and static electricity on the surface. A filter layer for color correction and color purity improvement prevents light having a wavelength between 580 nm and 590 nm from being emitted to the viewer so as to enhance a color correction range and correct white deviation.

A filter layer for near infrared ray absorption prevents light having a wavelength between 800 nm and 1200 nm from being emitted to the viewer so as to prevent malfunctioning of the plasma display apparatus 100 by interference with a wavelength band of a remote control. A filter layer for EMI blocking reduces EMI emitted toward the front surface of the panel 110.

The TSS 120 is attached onto a rear surface of the lower panel 113. The TSS 120 is used to dissipate the heat from the plasma display apparatus 100.

In addition, the TSS 120 is connected to the base chassis 140 through the gasket 130 so as to block EMI. That is, since energy of a driving wave causing discharge emits EMI using the electrodes on the panel 110 as an antenna by the voltage and the current which are applied to the X electrodes and the Y electrodes, the TSS 120 is connected to the base chassis 140 through the gasket 130 so as to reduce EMI emission. In particular, the TSS 120 is divided into portions so as to shorten a return path of electric current, thereby reducing EMI emission. Detailed methods for blocking EMI according to exemplary embodiments are described later. The TSS 120 may be implemented as an E-Graf.

In this exemplary embodiment, the TSS 120 is used to dissipate the heat and block the EMI, but this is merely an example. Even when a sheet to dissipate the heat and a sheet to block the EMI are separately provided, technical aspects of the exemplary embodiments can be applied. Furthermore, if it is not necessary to dissipate the heat or if the heat can be dissipated by other methods, it is also possible to provide only a plurality of sheets to block the EMI.

In order to connect the TSS 120 with the base chassis 140, the gasket 130 may be formed of a bondable substance. In particular, in order to transmit the electric current from the TSS 120 to the base chassis 140, the gasket 130 is formed of a conductive material such as a metal fabric. That is, the gasket 130 connects the TSS 120 and the base chassis 140 electrically so that the base chassis 140 can be used as the ground and the return path can be provided between the TSS 120 and the base chassis 140.

Two gaskets 130 are provided in the embodiment as illustrated in FIG. 2, or there may be three or more gaskets 130. The reason that there are a plurality of gaskets 130 is that the TSS 120 consists of a plurality of divided portions. More specifically, the gaskets 130 connect the TSS 120 with the base chassis 140 electrically so as to form the return path.

The base chassis 140 accommodates the driving circuit 150, and grounds the electric current generated by the driving circuit 150. In particular, the base chassis 140 grounds the electric current which is generated by the driving circuit 150 and is transmitted through the electrodes which are connected to the driving circuit 150, a panel capacitor, the TSS 120, and the gasket 130.

The driving circuit 150 may include an X driving circuit, a Y driving circuit, an address driving circuit, a power supply circuit, and a control circuit, as illustrated in FIG. 2. The X driving circuit, the Y driving circuit, and the address driving circuit transmit an X electrode driving signal, a Y electrode driving signal, and an address electrode driving signal to the X electrodes, the Y electrodes, and the address electrodes, respectively, so as to drive the panel 110.

The cover 160 covers a portion of the front surface of the panel 110, and the side and the rear surface of the panel 110 so as to prevent damage of the panel 110 and the driving circuit 150. The cover 160 may block EMI emitted from the back of the plasma display apparatus 100, and may thus be formed of a conductive material.

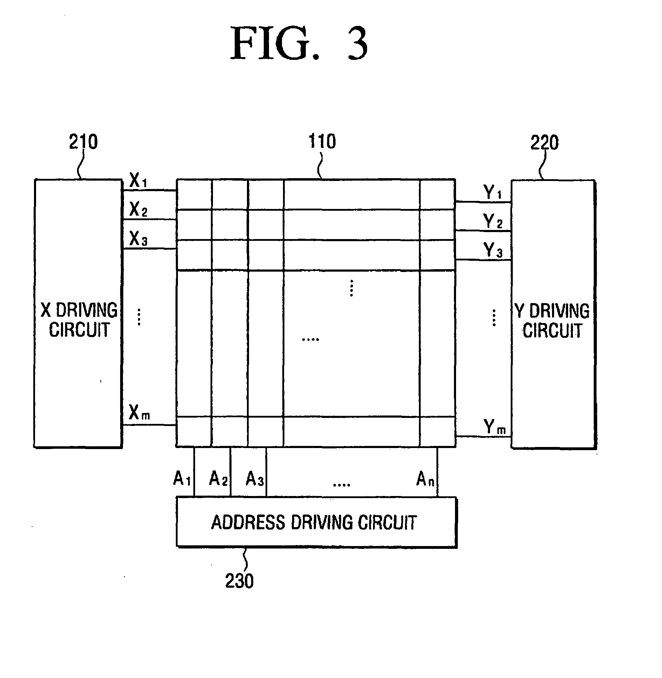

Hereinafter, a method for operating the plasma display apparatus 100 according to an exemplary embodiment is described with reference to FIG. 3. FIG. 3 illustrates a method for operating the plasma display apparatus 100 according to an exemplary embodiment.

Referring to FIG. 3, the X driving circuit 210 is connected to the X electrodes and transmits the driving voltage to the X electrodes so as to operate the panel 110. The Y driving circuit 220 is connected to the Y electrodes and transmits the driving voltage to the Y electrodes so as to operate the panel 110. In particular, the X driving circuit 210 and the Y driving circuit 220 perform sustain discharge of a selected pixel by alternately inputting the sustain voltage to the X electrodes and the Y electrodes.

The address driving circuit 230 transmits a data signal to select a pixel on which an image is displayed to an address electrode. The X electrodes and the Y electrodes are at right angles to the address electrodes, and face each other with a discharge space therebetween. The discharge space in which the X electrodes, the Y electrodes, and the address electrodes cross one another forms the discharge cells.

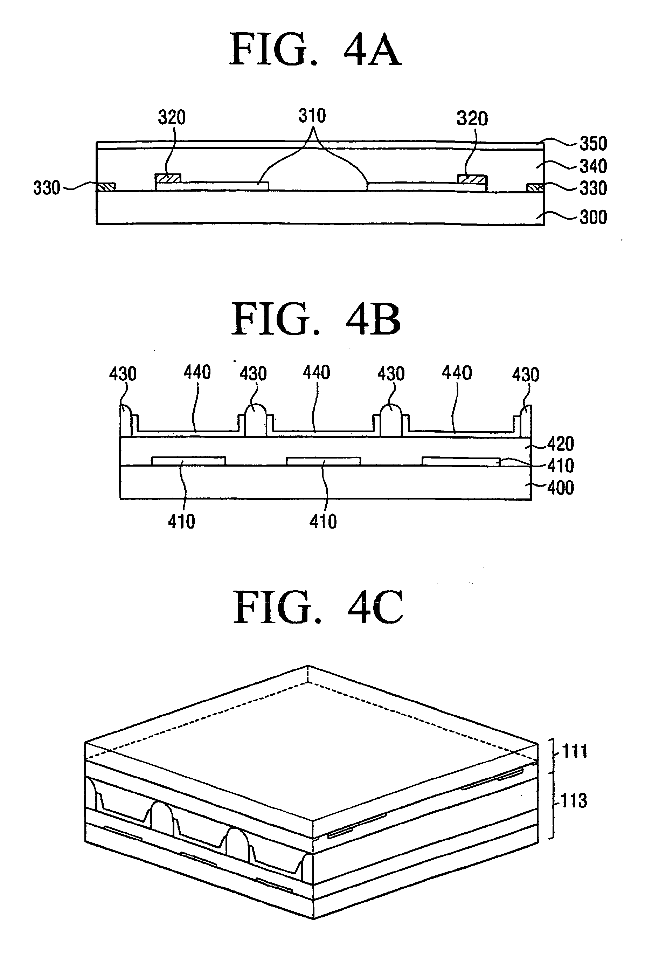

A detailed structure of the panel 110 according to an exemplary embodiment is described with reference to FIGS. 4A to 4C. FIGs. 4A to 4C illustrate the detailed structure of the panel 110 according to an exemplary embodiment.

Referring to FIG. 4A, in order to manufacture the upper panel 111, an upper glass 300 is formed or provided first, and indium tin oxide (ITO) electrodes 310 are patterned on the upper glass 300. The ITO electrode 310 is a kind of transparent electrode which is used to prevent light generated between X electrodes and Y electrodes from being hidden by the opaque X electrodes and the opaque Y electrodes and thereby not being viewed.

After the ITO electrodes 310 are patterned on the upper glass 300, bus electrodes (i.e., the X electrodes and the Y electrodes) 320 are patterned on the ITO electrodes 310. The X electrodes and the Y electrodes alternately receive the sustain voltage and perform a sustain discharge for a selected pixel.

After the bus electrodes 320 are patterned on the ITO electrodes 310, black stripes 330 are patterned on the upper glass 300. The black stripes 330 are provided between the pixels so as to maintain the separated state between the pixels.

After the black stripes 330 are patterned on the upper glass 300, a dielectric layer 340 and a magnesium oxide (MgO) protective layer 350 are disposed thereon. The dielectric layer 340 and the MgO protective layer 350 generate plasma stably by maintaining insulation between the address electrodes and the bus electrodes 320, and prevent the electrodes from being eroded by the plasma.

Referring to FIG. 4B, in order to manufacture the lower panel 113, a lower glass 400 is formed or provided first and address electrodes 410 are patterned on the lower glass 400. The address electrodes 410 are used to transmit a data signal to select a pixel to be displayed.

After the address electrodes 410 are patterned on the lower glass 400, a dielectric layer 420 is disposed thereon. As described above, the dielectric layer 420 generates plasma stably by maintaining insulation between the address electrodes 410 and the bus electrodes 320, and prevents the electrodes from being eroded by the plasma.

Partitions 430 are formed or provided on the dielectric layer 420. The partitions 430 block a fluorescent substance so that a red (R) pixel, a green (G) pixel, and a blue (B) pixel can be distinguished.

After the partitions 430 are provided on the dielectric layer 420, a fluorescent substance 440 is formed between the partitions 430 and then the sealing substance 112 such as frit is filled therein. By this process, the lower panel 113 is manufactured.

After the upper panel 111 and the lower panel 113 are manufactured, assembly and bonding of the upper panel 111 and the lower panel 113, gas injection, aging, lighting inspection, etc., are performed so that the panel 110 is formed as illustrated in FIG. 4C.

Referring to FIG. 3, the panel 110 manufactured according to the above process includes a plurality of pixels arranged in matrix form. In each pixel, an X electrode, a Y electrode, and an address electrode are provided. The panel 110 is operated in an address display separate (ADS) operating method in which the voltage is transmitted to each electrode so that each pixel emits light. In the ADS operating method, each sub-field of the panel 110 is divided into a reset section, an address section, and a sustain section.

The reset section eliminates a previous wall charge state and sets up wall charges to perform the next address discharge stably. The address section selects turned-on cells and turned-off cells and stacks wall charges in the turned-on cells (i.e., addressed cells). The sustain discharge section alternately transmits the sustain voltage to the X electrode and the Y electrode and performs a discharge to display an image on the addressed cells.

The panel 110 is operated by creating the discharge using a difference between the voltage transmitted to the X electrode and the voltage transmitted to the Y electrode and emitting light using plasma generated by discharge.

As described above, the X electrodes and the Y electrodes face each other with a discharge space therebetween. The discharge space in which the X electrodes, the Y electrodes, and the address electrodes cross one another forms the discharge cells.

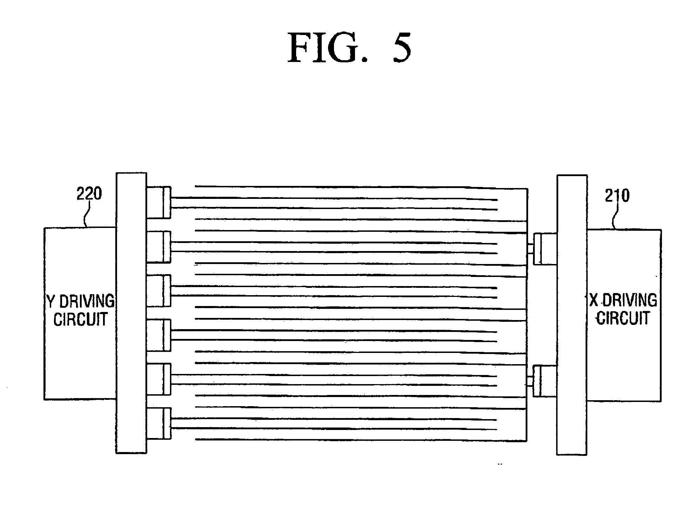

The form of arrangement of the X electrodes and the Y electrodes is related to the form of division of the TSS 120, and is thus described with reference to FIG. 5.

FIG. 5 illustrates a form of arrangement of electrodes according to an exemplary embodiment. In particular, FIG. 5 shows the electrodes without the upper panel 111 and the lower panel 113. In FIG. 5, the address driving circuit 230 and address electrodes are not illustrated, and the X driving circuit 210 and the Y driving circuit 220 are illustrated on both sides of the electrodes for convenience of description.

As described above, the X driving circuit 210 and the Y driving circuit 220 alternately input the sustain voltage to the X electrodes and the Y electrodes, so that the electric current is transmitted to the X electrodes and the Y electrodes and a sustain discharge of a selected pixel is caused.

The X electrodes are connected to the X driving circuit 210, and the electric current is transmitted in the X electrodes from the X driving circuit 210 to the Y driving circuit 220. The Y electrodes are connected to the Y driving circuit 220, and the electric current is transmitted in the Y electrodes from the Y driving circuit 220 to the X driving circuit 210. Since a high voltage of approximately 200 V and an RMS electric current of greater than approximately 2 A are transmitted to the X electrodes and the Y electrodes, energy of a driving wave creating the discharge emits EMI using the electrodes on the panel 110 as an antenna.

In order to solve this problem, EMI emitted from the X electrodes and the Y electrodes is transmitted to the TSS 120 and is grounded by the base chassis 140. In order to solve this problem more effectively, the TSS 130 which is divided into a plurality of portions is used and is connected to the base chassis 140 through the gaskets 130.

In particular, since the X electrodes and the Y electrodes are disposed horizontally, that is, from the X driving circuit 210 to the Y driving circuit 220 or from the Y driving circuit 220 to the X driving circuit 210, the TSS 120 which is divided vertically is used to shorten the return path of the electric current.

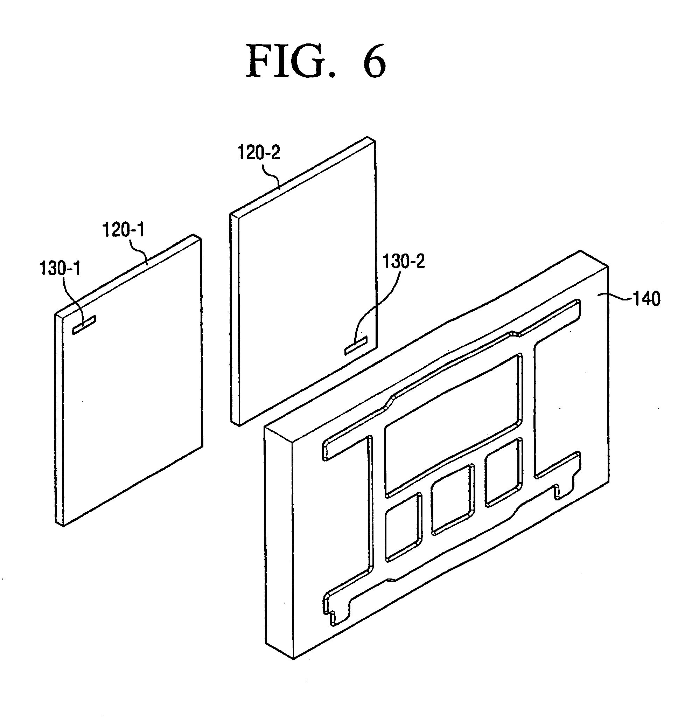

A detailed description is given with reference to FIG. 6. FIG. 6 illustrates a form of the TSS 120 and a structure of a connection between the TSS 120 and the base chassis 140 according to an exemplary embodiment. As illustrated in FIG. 6, the TSS 120 is disposed between the panel 110 and the base chassis 140.

The TSS 120 is divided into two portions, that is, a left portion 120-1 and a right portion 120-2, and is attached to the rear surface of the lower panel 113. Each portion 120-1 and 120-2 of the TSS 120 is not connected directly to the base chassis 140, but is connected to the base chassis 140 through each gasket 130-1 and 130-2.

If the electric current transmitted to the X electrodes and the Y electrodes is transmitted to the TSS 120, the TSS 120 forms a capacitance using the lower panel 113 as a dielectric substance.

In addition, the electric current transmitted to the TSS 120 is transmitted back to the base chassis 140 through the gaskets 130 which are connected to the TSS 120, and is transmitted back to the driving circuit 150 which is connected to the base chassis 140. Consequently, the electric current generated by the driving circuit 150 returns to the driving circuit 150 through the electrodes, the TSS 120, the gaskets 130, and the base chassis 140, and the capacitance is formed between the electrodes and the TSS 120.

The reason for the TSS 120 having the divided portions 120-1 and 120-2 is that if a path along which the electric current returns is large, the capacitance between the electrodes and the TSS 120 increases, thereby comparatively increasing EMI emission, whereas if a path along which the electric current returns is small, the capacitance between the electrodes and the TSS 120 decreases, thereby comparatively reducing EMI emission.

The reason that the TSS 120 is connected to the base chassis 140 through the gaskets 130 is that the TSS 120 is partially connected to the base chassis 140 through the conductive substance so as to form a return path of the electric current. The return path of the electric current is described below.

The electric current which is generated in the electrodes and is transmitted to a left TSS 120-1 returns to the driving circuit 150 through the gasket 130-1 attached to the left TSS 120-1 and the base chassis 140. The electric current which is generated in the electrodes and is transmitted to a right TSS 120-2 returns to the driving circuit 150 through the gasket 130-2 attached to the right TSS 120-2 and the base chassis 140.

Accordingly, compared with a TSS having only a single portion, the TSS 120 having the two portions 120-1 and 120-2 has a small return path. In addition, as described above, since the return path becomes small, the capacitance between the electrodes and the TSS 120-1 and 120-2 decreases, thereby comparatively reducing EMI emission.

In this exemplary embodiment, the reason that the TSS 120 is vertically divided into the two portions 120-1 and 120-2 is that since the X electrodes and the Y electrodes are formed from left to right or from right to left, the return path of the electric current is formed from left to right or from right to left. In order to reduce the return path, the TSS 120 is vertically divided into the two portions 120-1 and 120-2.

However, dividing the TSS 120 into the two portions 120-1 and 120-2 including the left and right portions is merely an example for convenience of description. The technical aspects of the exemplary embodiments can be applied when horizontally dividing the TSS 120 into two portions, when vertically and horizontally dividing the TSS 120 into four portions, or when dividing the TSS 120 into more than four portions.

The TSS 120 does not need to be divided in a predetermined division method in an exemplary embodiment, but may be divided in various methods or various forms according to the size of the plasma display apparatus 100 or the usage environment. That is, even though divided forms of the TSS 120, the size of the divided portions, and the distance between the divided portions may vary, if these are performed to reduce the return path of the electric current, the technical aspects of the exemplary embodiments can be applied thereto.

The divided portions 120-1 and 120-2 of the TSS 120 do not need to be connected to the base chassis 140 through one respective gasket 130, but may be connected to the base chassis 140 through two or more respective gaskets 130. However, in order to form the return path of the electric current of the electrodes from the TSS 120 to the base chassis 140, the divided portions 120-1 and 120-2 of the TSS 120 are connected to the base chassis 140 through at least one respective gasket 130.

This is merely an example.

As illustrated in FIG. 6, if one respective gasket 130 is attached to the two divided portions of the TSS 120, the gasket 130-1 is attached to the left upper side of the left TSS 120-1, and the gasket 130-2 is attached to the right lower side of the right TSS 120-2.

The gasket 130 is attached to the TSS 120 in this manner so as to minimize the return path of the electric current. The gasket 130 may be attached to the TSS 120 in other manners, and may be attached to the TSS 120 in a manner in which EMI emission is minimized according to the experimental results.

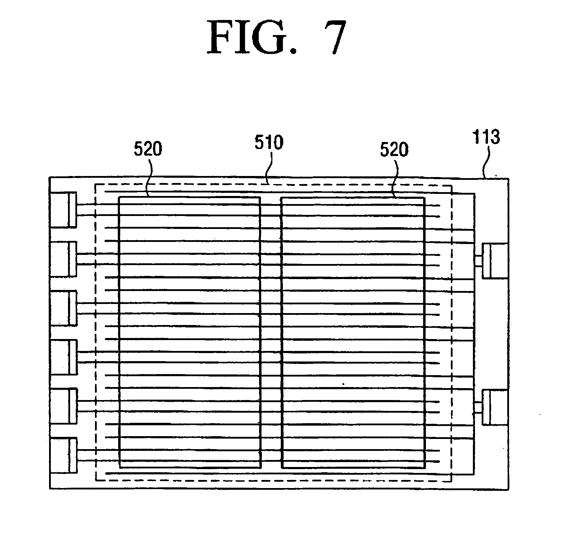

The TSS 120 is attached to an active area of the panel 110. The active area is described with reference to FIG. 7. FIG. 7 illustrates the active area of the panel 110 according to an exemplary embodiment, in which the upper panel 111 is not illustrated and the lower panel 113 is illustrated.

The active area 510 indicates an area in which the electrodes are arranged. As illustrated in FIG. 7, the electrodes are not disposed on the entire area perpendicular to the lower panel 113, but flexible printed circuits (FPCs) are disposed on both edges of the lower panel 113 so as to connect the driving circuit 150 with the electrodes. Therefore, the active area 510 is smaller than the size of the lower panel 113.

That is, the active area in which the electrodes are arranged and from which EMI is emitted is included in an area perpendicular to the lower panel 113, and the TSS 120 is included in an area perpendicular to the active area.

As described above, since EMI is emitted due to the voltage and the electric current which are transmitted to the X electrodes and the Y electrodes, the TSS 120 having the portions 120-1 and 120-2 divided to block EMI does not need to be attached to the entire area of the rear surface of the lower panel 113, and is attached to an area 520 which is the same as or smaller than the active area 510.

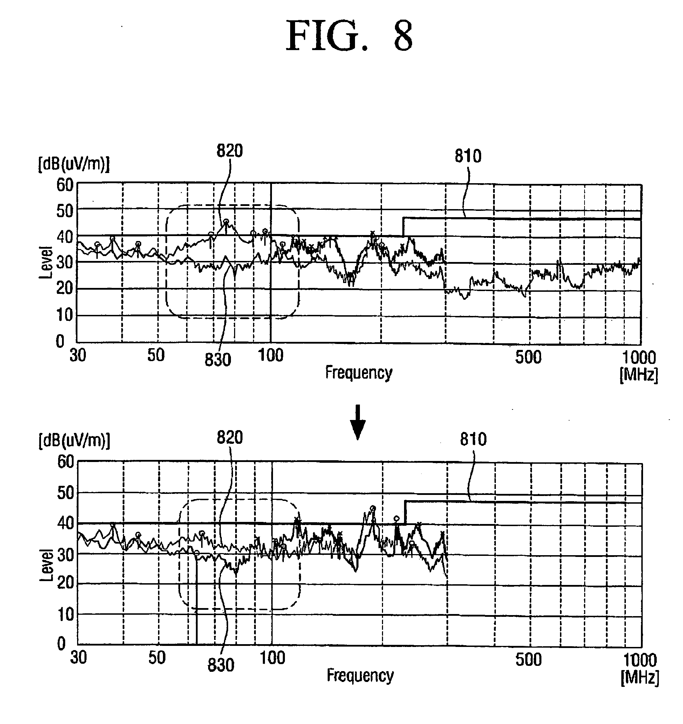

Hereinafter, the effect of EMI emission reduced using the TSS 120 having the divided portions 120-1 and 120-2 is described with reference to FIG. 8. FIG. 8 illustrates amounts of emitted EMI according to the form of the TSS 120 according to an exemplary embodiment.

In FIG. 8, the upper graph illustrates an amount of emitted EMI when the TSS 120 is not divided, and the lower graph illustrates an amount of emitted EMI when the TSS 120 is divided into the left and right portions 120-1 and 120-2 according to an exemplary embodiment.

In particular, a reference line 810 is the reference of an amount of emitted EMI according to the international standard, wave I 820 is a value of EMI measured according to each frequency based on a horizontal frequency, and wave II 830 is a value of EMI measured according to each frequency based on a vertical frequency.

As illustrated, an amount of emitted EMI when the TSS 120 is divided according to an exemplary embodiment is lower than an amount of emitted EMI when the TSS 120 is not divided, regardless of the horizontal frequency or the vertical frequency. In particular, comparing the peak/quasi-peak (QP) when the TSS 120 is divided with the peak/QP when the TSS 120 is not divided, the peak/QP when the TSS 120 is divided is approximately 5dB-10dB lower than the peak/QP when the TSS 120 is not divided. The QP indicates the quasi-peak of the amount of emitted EMI.

As described above, emission of EMI generated while the plasma display panel is operating can be effectively reduced by using the TSS 120 of the divided structure according to the exemplary embodiments.

The foregoing exemplary embodiments are merely exemplary and are not to be construed as limiting the present invention. The present teaching can be readily applied to other types of apparatuses. Also, the description of the exemplary embodiments is intended to be illustrative, and not to limit the scope of the claims, and many alternatives, modifications, and variations will be apparent to those skilled in the art.

## Claims

1. A plasma display apparatus, comprising:
a display panel (110), which comprises an upper panel (111), a driving electrode, and a lower panel (113);
a plurality of conductive sheets (120) comprising first surfaces connected to a rear surface of the lower panel (113) and second surfaces; and
a base chassis (140), which is electrically connected to the second surfaces of the plurality of conductive sheets (120),
**CHARACTERIZED BY**
a plurality of conductive substances (130) each electrically connecting one of the plurality of conductive sheets (120) and the base chassis (140), wherein the conductive sheets (120) form a capacitance using the lower panel (113) as a dielectric substance.

2. The plasma display apparatus according to claim 1, wherein the plurality of conductive substances (130) are a plurality of conductive gaskets (130), and the base chassis (140) is connected to one of the second surfaces of the plurality of conductive sheets (120) through at least one corresponding conductive gasket (130).

3. The plasma display apparatus according to claim 1 or claim 2, wherein the plurality of conductive sheets (120) are a plurality of thermal spread sheets (TSSs) which dissipate heat from the plasma display apparatus (100), and the plurality of conductive sheets (120) are arranged parallel to or perpendicular to a direction in which the driving electrode is arranged.

4. The plasma display apparatus according to any one of claims 1 to 3, further comprising:
a driving circuit (150), which is mounted on a surface of the base chassis (140) opposite a surface of the base chassis which is connected to the plurality of conductive sheets (120), and which is connected to the driving electrode,
wherein an electric current which is generated by the driving circuit (150) and is transmitted to the driving electrode returns to the driving circuit (150) through the plurality of conductive sheets (120) and the base chassis (140).

5. The plasma display apparatus according to claim 4, wherein the plurality of conductive sheets are formed to shorten a return path of the electric current.

6. The plasma display apparatus according to claim 5, wherein the plurality of conductive sheets (120) are arranged parallel to or perpendicular to a direction in which the driving electrode is arranged.

7. The plasma display apparatus according to any one of claims 1 to 6, wherein the plurality of conductive sheets (120) are divided in a form so that a capacitance formed between each of the plurality of conductive sheets (120) and the driving electrode is reduced as compared with when the plurality of conductive sheets are integrated as a single conductive sheet.

8. The plasma display apparatus according to any one of claims 1 to 7, wherein an active area in which the driving electrode is arranged and from which electromagnetic interference (EMI) is emitted is included in an area parallel to the lower panel, and an area for the plurality of conductive sheets (120) is included in an area perpendicular to the active area.

9. The plasma display apparatus according to any one of claims 1 to 8, wherein the plurality of conductive sheets (120) comprising:
a first conductive sheet (120-1), which is attached to a first area of a display panel (110);
a second conductive sheet (120-2), which is attached to a second area of the display panel (110) and is spaced apart by a distance from the first conductive sheet (120-1); and
wherein the base chassis (140) is connected to the first conductive sheet (120-1) through at least one first conductive connection element (130-1), and is connected to the second conductive sheet (120-2) through at least one second conductive connection element (130-2).

10. The plasma display apparatus according to claim 9, wherein the distance is a predetermined distance at a level of EMI generated by the display panel (110) is minimized.

11. The plasma display apparatus according to claim 9 or claim 10, wherein the first area of the display panel (110) is adjacent to an X driving circuit which drives the display panel (110), and the second area of the display panel (110) is adjacent to a Y driving circuit which drives the display panel (110).

## Patentansprüche

1. Plasmaanzeigevorrichtung, umfassend:
eine Anzeigetafel (110), die eine obere Tafel (111), eine Ansteuerungselektrode und eine untere Tafel (113) umfasst;
mehrere leitende Flächengebilde (120) mit ersten Flächen, die mit einer rückwärtigen Fläche der unteren Tafel (113) verbunden sind, und zweiten Flächen; und
ein Grundgestell (140), das mit den zweiten Flächen der mehreren leitenden Flächengebilde (120) elektrisch verbunden ist,
**GEKENNZEICHNET DURCH**
mehrere leitende Substanzen (130), die jeweils eines der mehreren leitenden Flächengebilde (120) und das Grundgestell (140) elektrisch verbinden, wobei die leitenden Flächengebilde (120) eine Kapazität bilden unter Verwendung der unteren Tafel (113) als dielektrische Substanz.

2. Plasmaanzeigevorrichtung nach Anspruch 1, wobei die mehreren leitenden Substanzen (130) mehrere leitende Dichtungen (130) sind, und das Grundgestell (140) mit einer der zweiten Flächen der mehreren leitenden Flächengebilde (120) durch zumindest eine entsprechende leitende Dichtung (130) verbunden ist.

3. Plasmaanzeigevorrichtung nach Anspruch 1 oder Anspruch 2, wobei die mehreren leitenden Flächengebilde (120) mehrere Wärmeverteilungsflächengebilde (TSS's: Thermal Spread Sheets) sind, die Wärme aus der Plasmaanzeigevorrichtung (100) abführen, und die mehreren leitenden Flächengebilde (120) parallel oder perpendikular zu einer Richtung angeordnet sind, in der die Ansteuerungselektrode angeordnet ist.

4. Plasmaanzeigevorrichtung nach einem der Ansprüche 1 bis 3, die weiterhin umfasst:
eine Ansteuerungsschaltung (150), die auf einer Fläche des Grundgestells (140) gegenüber einer Fläche des Grundgestells, die mit den mehreren leitenden Flächengebilden (120) verbunden ist, angebracht ist und die mit der Ansteuerungselektrode verbunden ist,
wobei elektrischer Strom, der von der Ansteuerungsschaltung (150) erzeugt wird und zur Ansteuerungselektrode geleitet wird, zur Ansteuerungsschaltung (150) durch die mehreren leitenden Flächengebilde (120) und das Grundgestell (140) zurückströmt.

5. Plasmaanzeigevorrichtung nach Anspruch 4, wobei die mehreren leitenden Flächengebilde ausgebildet sind, um einen Rückkehrpfad des elektrischen Stroms zu verkürzen.

6. Plasmaanzeigevorrichtung nach Anspruch 5, wobei die mehreren leitenden Flächengebilde (120) parallel oder perpendikular zu einer Richtung angeordnet sind, in der die Ansteuerungselektrode angeordnet ist.

7. Plasmaanzeigevorrichtung nach einem der Ansprüche 1 bis 6, wobei die mehreren leitenden Flächengebilde (120) in solcher Form aufgeteilt sind, dass eine zwischen jedem der mehreren leitenden Flächengebilde (120) und der Ansteuerungselektrode gebildete Kapazität gesenkt wird gegenüber dem, wenn die mehreren leitenden Flächengebilde als leitendes Einzelflächengebilde integriert sind.

8. Plasmaanzeigevorrichtung nach einem der Ansprüche 1 bis 7, wobei ein aktiver Bereich, in dem die Ansteuerungselektrode angeordnet ist und aus dem elektromagnetische Interferenz (EMI) emittiert wird, in einem zur unteren Tafel parallelen Bereich enthalten ist, und ein Bereich für die mehreren leitenden Flächengebilde (120) in einem zum aktiven Bereich perpendikularen Bereich enthalten ist.

9. Plasmaanzeigevorrichtung nach einem der Ansprüche 1 bis 8, wobei die mehreren leitenden Flächengebilde (120) umfassen:
ein erstes leitendes Flächengebilde (120-1), das an einem ersten Bereich einer Anzeigetafel (110) befestigt ist;
ein zweites leitendes Flächengebilde (120-2), das an einem zweiten Bereich der Anzeigetafel (110) befestigt ist und um eine Distanz vom ersten leitenden Flächengebilde (120-1) beabstandet ist; und
wobei das Grundgestell (140) mit dem ersten leitenden Flächengebilde (120-1) durch zumindest ein erstes leitendes Verbindungselement (130-1) verbunden ist, und mit dem zweiten leitenden Flächengebilde (120-2) durch zumindest ein zweites leitendes Verbindungselement (130-2) verbunden ist.

10. Plasmaanzeigevorrichtung nach Anspruch 9, wobei die Distanz eine vorgegebene Distanz ist, bei der ein Pegel von der Anzeigetafel (110) erzeugter EMI minimiert wird.

11. Plasmaanzeigevorrichtung nach Anspruch 9 oder Anspruch 10, wobei der erste Bereich der Anzeigetafel (110) angrenzend an eine X-Ansteuerungsschaltung ist, die die Anzeigetafel (110) ansteuert, und der zweite Bereich der Anzeigetafel (110) angrenzend an eine Y-Ansteuerungsschaltung ist, die die Anzeigetafel (110) ansteuert.

## Revendications

1. Appareil à écran plasma, comprenant :
un panneau d'affichage (110) qui comprend un panneau supérieur (111), une électrode de commande et un panneau inférieur (113) ;
une pluralité de feuilles conductrices (120) comprenant des premières surfaces reliées à une surface arrière du panneau inférieur (113), et des secondes surfaces ; et
un châssis de base (140) qui est en liaison électrique avec les secondes surfaces de la pluralité de feuilles conductrices (120)
**CARACTÉRISÉ PAR**
une pluralité de substances conductrices (130) reliant chacune, par voie électrique, une feuille conductrice parmi la pluralité de feuilles conductrices (120) et le châssis de base (140), les feuilles conductrices (120) formant une capacitance en se servant du panneau inférieur (113) comme substance diélectrique.

2. Appareil à écran plasma selon la revendication 1, dans lequel la pluralité de substances conductrices (130) est une pluralité de joints conducteurs (130), et le châssis de base (140) est relié à l'une des secondes surfaces de la pluralité de feuilles conductrices (120) par l'intermédiaire d'au moins un joint conducteur (130) correspondant.

3. Appareil à écran plasma selon la revendication 1 ou la revendication 2, dans lequel la pluralité de feuilles conductrices (120) est une pluralité de feuilles de dissipation thermique qui dissipent la chaleur de l'appareil à écran plasma (100), et la pluralité de feuilles conductrices (120) est agencée parallèlement ou perpendiculairement à la direction dans laquelle est agencée l'électrode de commande.

4. Appareil à écran plasma selon l'une quelconque des revendications 1 à 3, comprenant en outre :
un circuit de commande (150) qui est monté sur une surface du châssis de base (140) sur une surface du châssis de base (140) opposée à celle en connexion avec la pluralité de feuilles conductrices (120), et qui est relié à l'électrode de commande,
dans lequel un courant électrique qui est généré par le circuit de commande (150) et transmis à l'électrode de commande est renvoyé au circuit de commande (150) par l'intermédiaire de la pluralité de feuilles conductrices (120) et du châssis de base (140).

5. Appareil à écran plasma selon la revendication 4, dans lequel les premières surfaces de la pluralité de feuilles conductrices sont formées pour réduire le trajet de retour du courant électrique.

6. Appareil à écran plasma selon la revendication 5, dans lequel la pluralité de feuilles conductrices (120) est agencée parallèlement ou perpendiculairement à la direction dans laquelle est agencée l'électrode de commande.

7. Appareil à écran plasma selon l'une quelconque des revendications 1 à 6, dans lequel la pluralité de feuilles conductrices (120) est divisée de manière permettant qu'une capacitance formée entre chaque feuille conductrice de la pluralité de feuilles conductrices (120) et l'électrode de commande soit réduite, comparativement à une situation dans laquelle la pluralité de feuilles conductrices est intégrée sous la forme d'une seule feuille conductrice.

8. Appareil à écran plasma selon l'une quelconque des revendications 1 à 7, dans lequel une zone active dans laquelle est agencée l'électrode de commande et à partir de laquelle sont émises des perturbations électromagnétiques est incluse dans une zone perpendiculaire au panneau inférieur, et une zone destinée à la pluralité de feuilles conductrices (120) est incluse dans une zone perpendiculaire à la zone active.

9. Appareil à écran plasma selon l'une quelconque des revendications 1 à 8, dans lequel la pluralité de feuilles conductrices (120) comprend :
une première feuille conductrice (120-1) qui est rattachée à une première zone d'un panneau d'affichage (110) ;
une seconde feuille conductrice (120-2) qui est rattachée à une seconde zone du panneau d'affichage (110) et est écartée de la première feuille conductrice (120-1) selon une certaine distance ; et
dans lequel le châssis de base (140) est relié à la première feuille conductrice (102-1) par le biais d'au moins un premier élément de liaison conducteur (130-1), et est relié à la seconde feuille conductrice (120-2) par le biais d'au moins un second élément de liaison conducteur (130-2).

10. Appareil à écran plasma selon la revendication 9, dans lequel la distance est une distance prédéterminée à laquelle le niveau des perturbations électromagnétiques générées par le panneau d'affichage (110) est réduit.

11. Appareil à écran plasma selon la revendication 9 ou la revendication 10, dans lequel la première zone du panneau d'affichage (110) est contiguë à un circuit de commande X qui commande le panneau d'affichage (110), et la seconde zone du panneau d'affichage (110) est contiguë à un circuit de commande Y qui commande le panneau d'affichage (110).
